(19) Europäisches Patentamt
European Patent Office
Office européen des brevets

(11) EP 4 534 621 A1

(12) **EUROPEAN PATENT APPLICATION**

(43) Date of publication:
**09.04.2025 Bulletin 2025/15**

(21) Application number: **24202658.1**

(22) Date of filing: **25.09.2024**

(51) International Patent Classification (IPC):
***C09G 1/02*** *(2006.01)* ***C09K 3/14*** *(2006.01)*

(52) Cooperative Patent Classification (CPC):
**C09G 1/02; C09K 3/1463**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.10.2023 KR 20230133164**

(71) Applicant: **SK enpulse Co., Ltd.**
**Pyeongtaek-si, Gyeonggi-do 17784 (KR)**

(72) Inventors:
- **HAN, Deok Su**
  **03142 Seoul (KR)**
- **PARK, Han Teo**
  **03142 Seoul (KR)**
- **CHOI, Yongsoo**
  **03142 Seoul (KR)**

(74) Representative: **BCKIP Part mbB**
**MK1**
**Landsbergerstraße 98, 3.Stock**
**80339 München (DE)**

(54) **POLISHING COMPOSITION FOR SEMICONDUCTOR PROCESS AND POLISHING METHOD OF SUBSTRATE USING THE SAME**

(57) A polishing composition for a semiconductor process includes abrasive particles, a polyoxyalkylene-based surfactant, and a skew inhibitor of Formula 1 below. The polyoxyalkylene-based surfactant has a hydrophile-lipophile balance (HLB) value of 13 or higher.

[Formula 1]

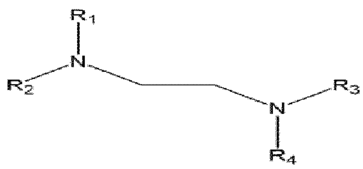

In Formula 1 above, $R_1$ is H, a methyl group or an ethyl group, and $R_2$, $R_3$, and $R_4$ are each independently a methyl or ethyl group. When the polishing composition having these characteristics is applied to the polishing of a substrate comprising two or more layers, the polishing composition can provide a smoother polished surface while maintaining a certain level of polishing speed.

EP 4 534 621 A1

## Description

This application claims the priority of Korean Patent Application No. 10-2023-0133164, filed on October 6, 2023.

## BACKGROUND

### 1. Field

The following description relates to polishing compositions for semiconductor processing and methods for polishing substrates using the same.

### 2. Description of the Related Art

As semiconductor devices become finer and more highly integrated, finer patterning techniques are being used. As a result, the surface structure of semiconductor devices is becoming more complex and steps between layers are becoming larger. In semiconductor device manufacturing, chemical mechanical polishing (CMP) is used as a planarization technique to remove steps in certain layers formed on a substrate.

In the CMP process, a substrate is pressurized and rotated while a slurry is supplied to a polishing pad to polish a surface of the substrate. Depending on the stage of the process, the material to be planarized varies, and the properties of the slurry applied also differ.

Polishing metal wiring after it has been formed requires sufficient polishing speed while minimizing dishing or erosion.

The foregoing background technology is technical information possessed or acquired by the inventor during the course of deriving the present disclosure and was not necessarily known to the public prior to the filing of the present application.

## SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one general aspect, a polishing composition for a semiconductor process includes abrasive particles, a polyoxyalkylene-based surfactant, and a skew inhibitor of Formula 1 below.

[Formula 1]

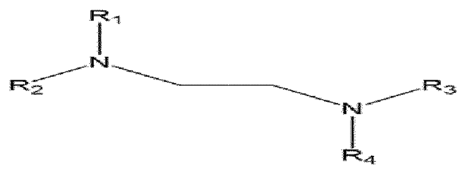

In Formula 1 above, $R_1$ is H, a methyl group, or an ethyl group, and $R_2$, $R_3$, and $R_4$ are each independently a methyl group or an ethyl group.

The polyoxyalkylene-based surfactant has a hydrophile-lipophile balance (HLB) value of 13 or higher.

The polyoxyalkylene-based surfactant may be a compound of Formula 2 below.

[Formula 2]

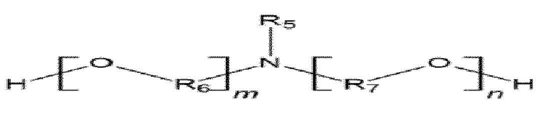

In Formula 2 above, $R_5$ may be an alkyl group having 10 to 30 carbon atoms.

Each of the $R_6$ and the $R_7$ may be independently a methyl group or an ethyl group.

Each of the m and the n may be an integer from 10 to 30 independently.

A ratio of a content (by weight) of the skew inhibitor to a content (by weight) of the polyoxyalkylene-based

surfactant may be from 0.3 to 1.2.

A weight average molecular weight of the polyoxyalkylene-based surfactant may be from 500 g/mol to 4,000 g/mol.

A surface charge of the abrasive particles may be positive.

The polishing composition may further include an anionic polymeric dispersant.

The anionic polymeric dispersant may include at least one compound selected from the group consisting of polyacrylic acid, polymethacrylic acid, polymaleic acid, and derivatives thereof.

The polishing composition may have a pH of 5.5 to 12.

A zeta potential of the polishing composition for the semiconductor process may be from -80 mV to -20 mV.

The polyoxyalkylene-based surfactant may be a dishing inhibitor for silicon oxide films.

The skew inhibitor may be for silicon nitride films.

In another general aspect, a method of manufacturing a substrate includes polishing a substrate to be polished by applying a slurry of a polishing composition. The polishing composition includes abrasive particles, a polyoxyalkylene-based surfactant, and a skew inhibitor of Formula 1 below.

[Formula 1]

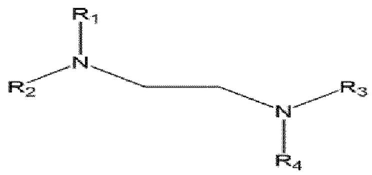

In Formula 1 above, $R_1$ is H, a methyl group, or an ethyl group, and $R_2$, $R_3$, and $R_4$ are each independently a methyl or ethyl group.

The polyoxyalkylene-based surfactant has a hydrophile-lipophile balance (HLB) value of 13 or higher.

Other features and aspects will be apparent from the following detailed description, the drawings, and the claims.

## DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences within and/or of operations described herein are merely examples, and are not limited to those set forth herein, but may be changed as will be apparent after an understanding of the disclosure of this application, except for sequences within and/or of operations necessarily occurring in a certain order. As another example, the sequences of and/or within operations may be performed in parallel, except for at least a portion of sequences of and/or within operations necessarily occurring in an order, e.g., a certain order. Also, descriptions of features that are known after an understanding of the disclosure of this application may be omitted for increased clarity and conciseness.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment, e.g., as to what an example or embodiment may include or implement, means that at least one example or embodiment exists where such a feature is included or implemented, while all examples are not limited thereto.

As used herein, the terms "about," "substantially," and the like are meant to be used at or near the numerical value when manufacturing and material tolerances inherent in the recited meanings are presented, and used to prevent unscrupulous infringers from taking unfair advantage of the disclosure where precise or absolute numerical values are recited to aid in the understanding of the embodiments.

Throughout the present disclosure, the term "combination thereof' as used in a Markush-style representation means one or more mixtures or combinations selected from the group of components described in the Markush-style representation, including one or more selected from the group of components.

Throughout the present disclosure, references to "A and/or B" mean "A, B, or both A and B".

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not

preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" specify the presence of stated features, numbers, operations, members, elements, and/or combinations thereof, other embodiments may exist where one or more of the stated features, numbers, operations, members, elements, and/or combinations thereof are not present.

Throughout the present disclosure, terms such as "first", "second" or "A", "B" are used to distinguish one from the other unless otherwise indicated.

As used herein, the reference to B being located on A means that B is located on A with or without other layers located therebetween, and is not to be construed as limiting B to being located abutting the surface of A.

In the present disclosure, singular expressions, unless otherwise indicated, are interpreted to include the singular or plural as construed from the context required.

As used herein, the term "~ based compound" is interpreted to include the ~ compound and derivatives thereof. For example, a polyoxyalkylene-based compound means a compound comprising polyoxyalkylene and derivatives thereof.

With the increasing integration of semiconductors, the density of patterns on wafers is increasing. When the patterned substrate is polished by the CMP process, defects can occur, such as dishing in the center of the pattern with a large width or corrosion of the insulating film (skew). The frequency of these defects tends to increase as the density of the pattern increases.

The inventors of the present disclosure have experimentally found that the application of a polyoxyalkylene-based surfactant and a skew inhibitor can provide a polishing composition capable of smoothing a substrate surface having two or more exposed films, particularly a silicon oxide film and a silicon nitride film, simultaneously at a polishing speed above a certain level.

Below, the present disclosure is described in detail.

A polishing composition for a semiconductor process according to an embodiment of the present disclosure includes abrasive particles, a polyoxyalkylene-based surfactant, and a skew inhibitor.

## Polyoxyalkylene-Based Surfactant

In the present disclosure, a polyoxyalkylene-based surfactant may be applied to the polishing composition. A polyoxyalkylene-based surfactant is a surfactant derived from a polyoxyalkylene-based compound.

The polyoxyalkylene-based surfactant is applied as a dishing inhibitor for the silicon oxide film. When polishing a substrate surface with an exposed silicon oxide film, the surfactant may be adsorbed to the surface of the silicon oxide film at a suitable strength. The adsorbed surfactant can help to effectively suppress the dishing phenomenon of the silicon oxide film while maintaining the polishing speed of the polishing composition above a certain level.

The polyoxyalkylene-based surfactant may be a non-ionic surfactant. The polyoxyalkylene-based surfactant may have a hydrophile-lipophile balance (HLB) value of 13 or higher.

In the present disclosure, the polyoxyalkylene-based surfactant having a controlled HLB value within a predetermined range may be stably dispersed in the polishing composition and may be readily adsorbed on the silicon oxide film exhibiting hydrophilic properties, thereby reliably preventing dishing of the silicon oxide film.

The HLB value for polyoxyalkylene-based surfactants is calculated according to Equation 1 below.

[Equation 1]

$$HLB = 20 \times \frac{M_h}{M}$$

In Equation 1 above, $M_h$ is the molecular weight of the hydrophilic portion of the polyoxyalkylene-based surfactant, and M is the molecular weight of the entire polyoxyalkylene-based surfactant.

Polyoxyalkylene-based surfactants may have an HLB value of 13 or higher. The HLB value may be 14 or higher. The HLB value may be 15 or higher. The HLB value may be less than 20. In such cases, the surfactant may be stably dispersed in the polishing composition and may be readily adsorbed onto the silicon oxide film.

The polyoxyalkylene-based surfactant may be a compound of Formula 2 below.

[Formula 2]

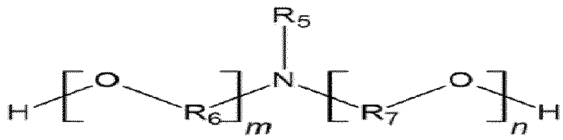

In Formula 2 above, $R_5$ is an alkyl group having a carbon number from 10 to 30, $R_6$ and $R_7$ are each independently a methyl group or an ethyl group, and m and n are each independently an integer from 10 to 30.

In a polyoxyalkylene-based surfactant having the composition of Formula 2, a portion comprising oxyalkylene-based repeating units (in Formula 2, -RsO- repeating units and $-R_7O$-repeating units) can form hydrogen bonds with a silicon oxide film to help form a stable passivation film on the oxide film. In addition, in the surfactant, the portion comprising an alkyl group (in Formula 2, $R_5$ functional group) can form a steric hindrance near the silicon oxide film, effectively inhibiting abrasive particles from excessively polishing the silicon oxide film.

In Formula 2, $R_5$ may be an alkyl group having a carbon number from 10 to 30. The carbon number may be 12 or more. The carbon number may be 25 or less. In such cases, the polishing composition can further smooth the substrate surface where the silicon oxide film is exposed and reliably prevent an excessive increase in the degree of agglomeration of the abrasive particles due to surfactant application.

In Formula 2, m and n are each independently an integer from 10 to 30. The m and n may each independently be an integer greater than or equal to 12. The m and n may each independently be an integer equal to or less than 25.

The sum of m and n can be an integer greater than or equal to 20. The sum of m and n can be an integer greater than or equal to 24. The sum of m and n may be an integer equal to or less than 60. The sum of m and n may be an integer equal to or less than 50. The sum of m and n may be an integer equal to or less than 40.

Polyoxyalkylene-based surfactants with these characteristics can be adsorbed with controlled intensity on the surface of the silicon oxide film and contribute to the improvement of the smoothness of the substrate surface. Polyoxyalkylene-based surfactants with these characteristics can also inhibit the interaction between the surfactant and the abrasive particles from reducing the dispersibility of the polishing composition.

The polyoxyalkylene-based surfactant may have a weight average molecular weight of 500 g/mol to 4,000 g/mol. The weight average molecular weight may be greater than or equal to 1,000 g/mol. The weight average molecular weight may be 3,000 g/mol or less. The weight average molecular weight may be 2,500 g/mol or less. In such cases, the dispersion of abrasive particles in the polishing composition by the addition of the surfactant can be reliably controlled, and the frequency of defects caused by excessive polishing of the silicon oxide film when polishing a substrate surface where the silicon oxide film is exposed can be effectively reduced.

The weight average molecular weight of polyoxyalkylene-based surfactant may be measured by gel permeation chromatography (GPC).

**Skew Inhibitor**

The polishing composition for a semiconductor process in the present disclosure may include a skew inhibitor of Formula 1 below.

[Formula 1]

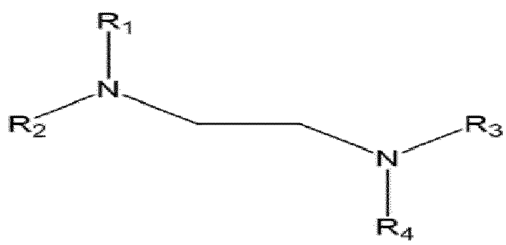

In Formula 1 above, $R_1$ is H, a methyl group or an ethyl group, and $R_2$, $R_3$, and $R_4$ are each independently a methyl group or an ethyl group.

The skew inhibitor of Formula 1 is a skew inhibitor for a silicon nitride film. When polishing the surface of a substrate comprising a silicon nitride film, the skew inhibitor can be adsorbed on the surface of the silicon nitride film to effectively inhibit excessive erosion of the silicon nitride film that may occur during the polishing process.

The polishing composition of the present disclosure may comprise both the polyoxyalkylene-based surfactant described above and a skew inhibitor according to Formula 1. This improves the polishing selectivity of the silicon oxide film to the silicon nitride film and enables smooth polishing of the substrate surface where both the silicon oxide film and the silicon nitride film are exposed together. Furthermore, despite the adsorption of the above compounds on the surface to be polished, the polishing composition may exhibit a polishing rate above a certain level.

In the present disclosure, a content ratio of polyoxyalkylene-based surfactant and skew inhibitor may be adjusted to reduce the frequency of defects in the polished surface and to improve the polishing selectivity of silicon oxide films to silicon nitride films while inhibiting excessive deterioration of the polishing speed and dispersibility of the polishing composition.

In the polishing composition for a semiconductor process, a ratio of a content (by weight) of the skew inhibitor to a content (by weight) of the polyoxyalkylene-based surfactant may be from 0.3 to 1.2. The ratio may be 0.4 or greater. The ratio may be greater than or equal to 0.45. The ratio may be 0.5 or greater. The ratio may be 0.6 or greater. The ratio may be greater than or equal to 0.7. The ratio may be 1.1 or less. The ratio may be 1.0 or less. In such cases, the polishing composition can efficiently reduce the frequency of defects on the polished surface while exhibiting stable dispersion, polishing speed, and polishing selectivity.

## Dispersant

In the present disclosure, an anionic polymeric dispersant may be further included in the polishing composition. The dispersant may be stretchable rather than condensed within the pH-controlled polishing composition. When such dispersant is adsorbed on an abrasive particle surface, particularly an abrasive particle surface with a positive surface charge, by electrostatic attraction, they can form significant steric hindrance around the abrasive particle, providing good dispersion in the polishing composition. This feature can contribute to reducing the frequency of scratches on the polished surface caused by abrasive particle agglomeration.

The anionic polymeric dispersant may comprise one or more compounds selected from the group consisting of polyacrylic acid, polymethacrylic acid, polymaleic acid, and derivatives thereof. The dispersant may include polyacrylic acid and derivatives thereof. The dispersant may comprise polyacrylic acid. The dispersant may be polyacrylic acid.

A weight average molecular weight of the anionic polymeric dispersant may be from 1,000 g/mol to 50,000 g/mol. The weight average molecular weight may be greater than or equal to 2,000 g/mol. The weight average molecular weight may be greater than or equal to 3,000 g/mol. The weight average molecular weight may be greater than or equal to 5,000 g/mol. The weight average molecular weight may be greater than or equal to 10,000 g/mol. The weight average molecular weight may be 40,000 g/mol or less. In such cases, an amount of dispersant adsorbed on the surface of the abrasive particle may be controlled to inhibit excessive reduction of the reaction sites of the abrasive particle and to maintain the polishing properties of the polishing composition at or above a certain level. At the same time, the dispersibility of the abrasive particle can be effectively improved.

A weight average molecular weight of the dispersant may be measured by gel permeation chromatography.

The polishing composition for a semiconductor process may comprise from 50 parts by weight to 200 parts by weight anionic polymeric dispersant based on 100 parts by weight of the abrasive particle. The polishing composition for semiconductor processes may comprise 60 parts by weight or more of an anionic polymeric dispersant based on 100 parts by weight of the abrasive particle. The polishing composition for a semiconductor process may comprise 70 parts by weight or more of anionic polymeric dispersant based on 100 parts by weight of the abrasive particle. The polishing composition for a semiconductor process may comprise 80 parts by weight or more of anionic polymeric dispersant based on 100 parts by weight of the abrasive particle. The polishing composition for a semiconductor process may comprise 90 parts by weight or more of anionic polymeric dispersant based on 100 parts by weight of the abrasive particle. The polishing composition for a semiconductor process may comprise 150 parts by weight or less of the anionic polymeric dispersant based on 100 parts by weight of the abrasive particle.

The polishing composition for a semiconductor process may comprise 0.15 wt% or more of an anionic polymeric dispersant. The polishing composition for a semiconductor process may comprise 0.2 wt% or more of an anionic polymeric dispersant. The polishing composition for a semiconductor process may comprise 0.25 wt% or more of an anionic polymeric dispersant. The polishing composition for a semiconductor process may comprise 0.5 wt% or less of an anionic polymeric dispersant.

In this case, it can help to stabilize the dispersion of the abrasive particles.

In the present disclosure, a zwitterionic dispersant having a molecular weight of 50 g/mol to 300 g/mol may be further included in the polishing composition. The zwitterionic dispersant with a controlled molecular weight may adsorb to portions of the abrasive particle surface where the anionic polymeric dispersant is not adsorbed additionally, further improving the dispersibility of the abrasive particle.

The zwitterionic dispersant may comprise anyone selected from the group consisting of picolinic acid, amino acids, and combinations thereof. The amino acid may exemplarily be at least one of glutamate, aspartate, glutamine,

tyrosine, tryptophan, serine, threonine, glycine, alanine, methionine, cysteine, phenylalanine, leucine, valine, and isoleucine. The zwitterionic dispersant may comprise picolinic acid. The zwitterionic dispersant may be picolinic acid.

The polishing composition for a semiconductor process may comprise 0.2 parts by weight to 15 parts by weight of zwitterionic dispersant based on 100 parts by weight of the abrasive particle. The polishing composition for a semiconductor process may comprise 0.5 parts by weight or more of the zwitterionic dispersant based on 100 parts by weight of the abrasive particle. The polishing composition for a semiconductor process may comprise 0.8 parts by weight or more of zwitterionic dispersant based on 100 parts by weight of the abrasive particle. The polishing composition for a semiconductor process may comprise 10 parts by weight or less of the zwitterionic dispersant based on 100 parts by weight of the abrasive particle. The polishing composition for a semiconductor process may comprise 8 parts by weight or less of zwitterionic dispersant based on 100 parts by weight of the abrasive particle. The polishing composition for a semiconductor process may comprise 5 parts by weight or less of the zwitterionic dispersant based on 100 parts by weight of the abrasive particle.

The polishing composition for a semiconductor process may comprise from 0.01 wt% to 0.5 wt% zwitterionic dispersant. The polishing composition for a semiconductor process may comprise 0.02 wt% or more of a zwitterionic dispersant. The polishing composition for a semiconductor process may comprise 0.03 wt% or more of a zwitterionic dispersant. The polishing composition for a semiconductor process may comprise 0.05 wt% or more of the zwitterionic dispersant. The polishing composition for a semiconductor process may comprise 0.4wt% or less of the zwitterionic dispersant. The polishing composition for a semiconductor process may comprise 0.3 wt% or less of the zwitterionic dispersant.

In this case, it can contribute to a more effective reduction in the frequency of scratches on the polished surface.

The polishing composition for a semiconductor process may further comprise a non-ionic polymeric dispersant. The non-ionic polymeric dispersant can be adsorbed on the abrasive particle to increase dispersibility, and the other non-ionic polymeric dispersant that is not adsorbed can further increase dispersion stability due to steric hindrance effect. Furthermore, since the dispersant is non-ionic, the dispersion stability of the polishing composition for the semiconductor process is more stable even in the acidic environment described below. In addition, occurrence of defects caused by polishing on the substrate during the polishing process can be reduced.

The non-ionic polymeric dispersant may be at least one selected from a group consisting of polyethylene glycol, polypropylene glycol, polyvinylpyrrolidone, polyethylene oxide, polypropylene oxide, polyalkyl oxide, polyoxyethylene oxide, polyethylene oxide-propylene oxide copolymer, cellulose, methylcellulose, methylhydroxyethylcellulose, methylhydroxypropylcellulose, hydroxyethylcellulose, carboxymethylcellulose, carboxymethylhydroxyethylcellulose, sulfoethylcellulose, and carboxymethylsulfoethylcellulose.

The non-ionic polymeric dispersant may have a weight average molecular weight of 1,000 g/mol to 25,000 g/mol. In this case, the non-ionic polymeric dispersant can exhibit better solubility, dispersion stability, etc. and may be suitable for a polishing composition with high polishing rate.

The non-ionic polymeric dispersant may be included from 0.01 to 5 wt% based on the polishing composition for a semiconductor process. The non-ionic polymeric dispersant may be included from 0.1 to 2 wt% based on the polishing composition for a semiconductor process. In this case, contamination, such as particle adhesion to the polished substrate surface, can be controlled below a certain level while suppressing the occurrence of defects on the polished substrate surface.

## Abrasive particle and Other Compounds

A surface charge of the abrasive particle may be positive. In this case, due to electrostatic attraction, the anionic polymeric dispersant can be readily adsorbed on the surface of the abrasive particle.

The abrasive particle may comprise any one selected from the group consisting of ceria, silica, zirconia, alumina, zeolite, and combinations thereof. The abrasive particle may comprise surface modified particles.

An abrasive particle may include ceria. The abrasive particle may be ceria. The ceria may react with the thin film to be polished during the polishing process to exhibit high polishing rate. Since the surface of the ceria has a positive charge, dispersibility of the abrasive particles by the anionic polymeric dispersant may be easily improved.

The abrasive particle may contain colloidal ceria particle. The abrasive particle may be colloidal ceria. The colloidal ceria may have a higher density and crystallinity compared to ceria formed by the solid phase synthesis method. These properties may impart improved polishing properties to the polishing composition. In addition, colloidal ceria may have a relatively uniform particle shape and particle size distribution, which can effectively reduce the frequency of defects on the polished surface.

The abrasive particle may have an average diameter of the secondary particle of 100 nm or more. The average diameter may be greater than or equal to 110 nm. The average diameter may be greater than or equal to 120 nm. The average diameter may be greater than or equal to 130 nm. The average diameter may be 170 nm or less. The average diameter may be 160 nm or less. The average diameter may be 150 nm or less. Polishing compositions with these particles

may exhibit a high polishing rate for a substrate surface to be polished while reducing the frequency of defects, such as scratches, on the polished surface.

The average diameter of the primary particle of the abrasive particle may be 30 nm or more. The average diameter may be 40 nm or more. The average diameter may be greater than or equal to 50 nm. The average diameter may be 200 nm or less. The average diameter may be 150 nm or less. The average diameter may be 120 nm or less. The average diameter may be 90 nm or less. In such cases, the polishing composition may exhibit a good polishing rate on the substrate surface while stably controlling the frequency of adhesion of the abrasive on the substrate to be polished.

The abrasive particle may include 50 wt% or more of ceria particle. The abrasive particle may include 70 wt% or more of ceria particle. The abrasive particle may include 90 wt% or more of ceria particle. The abrasive particle may include 100 wt% or less of ceria particle. The abrasive particle may be ceria particle.

The abrasive particle may include 50 wt% or more of colloidal ceria particle. The abrasive particle may include 70 wt% or more of colloidal ceria particle. The abrasive particle may include 90 wt% or more of colloidal ceria particle. The abrasive particle may include 100 wt% or less of colloidal ceria particle. The abrasive particle may be colloidal ceria particle.

The polishing composition for a semiconductor process may comprise 0.1 wt% or more of abrasive particle. The polishing composition for a semiconductor process may comprise 0.15 wt% or more of abrasive particle. The polishing composition for a semiconductor process may comprise 0.2 wt% or more of abrasive particle. The polishing composition for a semiconductor process may comprise less than or equal to 5 wt% of abrasive particle. The polishing composition for a semiconductor process may comprise less than or equal to 3 wt% of abrasive particle. The polishing composition for a semiconductor process may comprise 1.5 wt% or less of abrasive particle. In this case, efficient polishing is possible, especially, substrate surface where both oxide and nitride films are exposed together.

The polishing composition for a semiconductor process may further comprise a chelator. The chelator adsorbs metals or metal ions to facilitate their removal. Specifically, metals that may be generated during the polishing process are more likely to adhere to the polished surface or remain in subsequent processes and cause defects. In particular, metal such as tungsten are relatively easy to dissolve in certain environments but are also prone to adhering to surfaces. Therefore, chelators may be applied as a barrier to prevent this.

Exemplarily, the chelator may be at least one selected from the group consisting of butyric acid, citric acid, tartaric acid, succinic acid, oxalic acid, acetic acid, adipic acid, capric acid, caproic acid, caprylic acid, carboxylic acid, glutaric acid, glutamic acid, glycolic acid, thioglycolic acid, formic acid, mandelic acid, fumaric acid, lactic acid, lauric acid, malic acid, malonic acid, myristic acid, plamitic acid, phthalic acid, isophthalic acid, terephthalic acid, citraconic acid, propionic acid, pyruvic acid, stearic acid, valeric acid, benzoic acid, phenylacetic acid, naphthoic acid, aspartic acid, amino acid, and ethylenediaminetetraacetic acid. The amino acid may be one selected from a group consisting of glycine, $\alpha$-alanine, $\beta$-alanine, L-asparaginic acid, N-methylglycine (methylglycine), and combinations thereof.

The chelator may be any molecule containing two or more carboxyl groups or alcohol groups. More than one type of chelator comprising at least two carboxyl groups or alcohol groups in the molecule may be used as a chelating agent. Specifically, the chelator may comprise any one selected from the group consisting of ethylenediaminetetraacetic acid (EDTA), glycine, carboxylic acids, and combinations thereof. A carboxylic acid group is a compound that contains at least one carboxyl group in its molecule.

The chelator may be included in an amount of 0.003 to 0.5 wt% in the polishing composition for semiconductor processing. The chelator may be included in an amount of 0.005 to 0.3 wt% in the polishing composition for the semiconductor processing. In this case, the frequency of defects caused by particles derived from the metal thin film can be reduced.

The polishing composition for a semiconductor process may further comprise an oxidizing agent. The oxidizing agent oxidizes the metal thin film to make the film more easily planarized and improves polishing rate and etching rate.

The oxidizer includes hydrogen peroxide, urea peroxide, urea, percarbonate, periodic acid, periodate, perchloric acid, perchlorate, perbromic acid, perbromate, perboric acid, perborate, permanganic acid, permanganate, persulfate, bromate, chlorate, chlorite, chromate, iodate, iodic acid, ammonium persulfate, benzoyl peroxide, calcium peroxide, barium peroxide, sodium peroxide, and urea hydrogen peroxide.

The oxidizing agent may be included in an amount of 0.01 to 5 wt% in the polishing composition for the semiconductor process. In this case, the degree of oxidation of the metal thin film is controlled so that the polishing rate can be adjusted to a stable range.

To adjust the pH of a polishing composition for a semiconductor process, an acid may be added to the composition in addition to a solvent. The acid may be applied in combination with a pH adjusting agent.

For example, the acid may be at least one selected from the group consisting of hydrochloric acid, phosphoric acid, sulfuric acid, hydrofluoric acid, bromic acid, iodic acid, formic acid, malonic acid, oxalic acid, acetic acid, adipic acid, citric acid, propionic acid, fumaric acid, lactic acid, salicylic acid, pimelin, benzoic acid, succinic acid, phthalic acid, butyric acid, glutaric acid, glutamic acid, glycolic acid, asparagine acid, tartaric acid, and salts thereof.

The pH adjusting agent may be any one selected from the group consisting of ammonia, aminomethylpropanol,

tetramethylammonium hydroxide, potassium hydroxide, sodium hydroxide, magnesium hydroxide, rubidium hydroxide, cesium hydroxide, sodium bicarbonate, sodium carbonate, imidazole, and combinations thereof.

The acid and pH adjusting agent may be applied in appropriate amounts to achieve the intended pH.

The polishing composition for a semiconductor process may comprise each of the components described above and each of the additional components described hereinafter, plus a solvent as a residual amount. The solvent may be water, preferably ultrapure water.

## Properties of Polishing Composition

In the present disclosure, a pH of the polishing composition may be adjusted to help inhibition of aggregation of the abrasive particle. Specifically, when the pH of the polishing composition is adjusted, the anionic polymeric dispersant included in the polishing composition may remain stretched and not condensed when adsorbed on the surface of the abrasive particle, thereby forming a significant steric hindrance around the abrasive particle. This effectively prevents agglomeration between the abrasive particles.

The polishing composition for a semiconductor process may have a pH of 5.5 to 12. The pH may be 6 or more. The pH may be 7 or more. The pH may be 11 or less. The pH may be 10 or less. In such cases, the degree to which the dispersant condenses within the polishing composition may be controlled, which may contribute to improving the dispersibility of the polishing composition.

A zeta potential of the polishing composition for a semiconductor process may be from -80 mV to -20 mV. The zeta potential may be greater than or equal to -70 mV. The zeta potential may be greater than or equal to -60 mV. The zeta potential may be greater than or equal to -55 mV. The zeta potential may be -25 mV or less. The zeta potential may be -35 mV or less.

In this case, the dispersion of the polishing composition may be improved, and the frequency of scratches on the polished surface may be effectively reduced.

The pH and zeta potential of the polishing compositions are measured by methods commonly applied in the field of polishing compositions for semiconductor processing.

The polishing composition for a semiconductor process may have a polishing rate for the silicon oxide film of 1,000 Å/min or more. The polishing composition for a semiconductor process may have a polishing rate for the silicon oxide film of 1,100 Å/min or more. The polishing composition for a semiconductor process may have a polishing rate for the silicon oxide film of 1,200 Å/min or more. The polishing composition for a semiconductor process may have a polishing rate for the silicon oxide film of 3,000 Å/min or less.

The polishing composition for a semiconductor process may have a polishing rate for the silicon nitride film of 300 Å/min or less. The polishing composition for a semiconductor process may have a polishing rate for the silicon nitride film of 250 Å/min or less. The polishing composition for a semiconductor process may have a polishing rate for the silicon nitride film of 200 Å/min or less. The polishing composition for a semiconductor process may have a polishing rate for the silicon nitride film of 180 Å/min or less. The polishing composition for a semiconductor process may have a polishing rate for the silicon nitride film of 150 Å/min or less. The polishing composition for a semiconductor process may have a polishing rate for the silicon nitride film of 30 Å/min or more.

The polishing composition for a semiconductor process may have a polishing selectivity ratio of the silicon oxide film to the silicon nitride film of 10 or more. The polishing selectivity ratio may be 12 or more. The polishing selectivity ratio may be 15 or more. The polishing selectivity ratio may be 20 or more. The polishing selectivity ratio may be 35 or less. In such cases, generation of excessively large steps on the surface to be polished may be suppressed when etching the surface exposed to silicon oxide and silicon nitride films together.

When measuring the polishing rate of polishing composition for semiconductor process, the substrate to be polished is a patterned wafer with a pitch of 1,000 $\mu$m and a density of 50% of silicon oxide film and silicon nitride film, and the carrier/table speed is 93/87 RPM, the slurry flow rate is 100 ml/min, and the polishing pressure is 4.0 psi. When measuring the dishing value, the polishing pad is the HD-500C pad from SK enpulse Co., Ltd.

When polishing a substrate having a pattern comprising silicon nitride film and a silicon oxide film with pattern density of 50% by the polishing composition for a semiconductor process for 200 seconds, a dishing value measured from the silicon oxide film may be 600 Å or less.

When measuring the dishing value, the substrate to be polished is a patterned wafer with a pitch of 1,000 $\mu$m, a pattern including silicon oxide film and silicon nitride film density of 50%, a carrier/table speed of 93/87 RPM, a slurry flow rate of 100 ml/min, and a polishing pressure of 4.0 psi. When measuring the dishing value, the polishing pad is the HD-500C pad manufactured from SK enpulse Co., Ltd.

Polishing the substrate for 200 seconds means polishing a substrate having a smooth surface for 200 seconds or polishing a substrate having a step at the top and polishing the substrate for another 200 seconds from the point at which the substrate begins to have a smooth surface.

When polishing a substrate that has a pattern including a silicon nitride film and a silicon oxide film with pattern

density of 50% for 200 seconds by the polishing composition for a semiconductor process, a dishing value measured from the silicon oxide film may be 600 Å or less. The dishing value may be 500 Å or less. The dishing value may be 450 Å or less. The dishing value may be 400 Å or less. The dishing value may be 380 Å or less. The dishing value may be greater than or equal to 100 Å. The polishing composition having these characteristics may provide a smoother polishing surface.

When polishing a substrate that has a pattern including a silicon nitride film and a silicon oxide film with pattern density of 50% for 200 seconds by the polishing composition for a semiconductor process, a skew value measured from the silicon nitride film may be 500 Å or less.

The skew value of a silicon nitride film is the depth to which the silicon nitride film is abraded when polishing the substrate.

When measuring the skew of silicon nitride films, the polishing conditions are the same as when measuring the dishing value of silicon oxide films above.

When polishing a substrate that has a pattern including a silicon nitride film and a silicon oxide film with pattern density of 50% for 200 seconds by the polishing composition for a semiconductor process, a skew value measured from the silicon nitride film may be 500 Å or less. The skew value may be 400 Å or less. The skew value may be 350 Å or less. The skew value may be 300 Å or less. The skew value may be 280 Å or less. The skew value may be 250 Å or less. The skew value may be greater than or equal to 50 Å. In such cases, the degree of step generation on a polished surface due to the excessive abrasive can be effectively suppressed.

## Method of Manufacturing a Substrate

A method of manufacturing a substrate according to another embodiment of the present disclosure includes polishing the substrate by applying the polishing composition for a semiconductor process described above as a slurry.

The substrate may include at least one of an insulating film, metallic wiring, and a barrier layer on the top surface. The metallic wiring may comprise copper or tungsten. If the metallic wiring comprises copper, the barrier layer may comprise tantalum or nitride thereof. If the metallic wiring comprises tungsten, the barrier layer may comprise titanium or nitride thereof. The insulating film may comprise a silicon nitride film and/or a silicon oxide film.

Specifically, the process of polishing a substrate may be performed by bringing the substrate to be polished and a polishing pad into contact with the polishing composition for a semiconductor process supplied from a spray nozzle. In this time, the polishing head holding the substrate may be rotated and the table to which the polishing pad is attached may be also rotated.

The process of polishing the substrate may further comprise, if desired, conditioning the surface of the polishing pad prior to polishing.

A polishing composition for semiconductor processing may polish a wafer in contact with a polishing pad as the polishing composition penetrates toward the wafer.

In the process of polishing the substrate, a pressure of 6.89 kPa to 48.26 kPa may be applied to the substrate. The pressure may be from 13.79 kPa to 34.47 kPa.

The process of polishing the substrate can last from 50 seconds to 10 minutes. However, this can vary depending on the target degree of polishing.

The description of the polishing composition for semiconductor processes is redundant to the foregoing and is therefore omitted.

The method of manufacturing the substrate may further comprise the step of performing a cleaning process to clean the polished substrate.

The cleaning process may be carried out by cleaning the polished substrate through purified water and/or inert gas.

Specific examples are described in more detail below.

### Manufacturing Example: Manufacturing of Polishing Compositions for Semiconductor Processing

Example 1: A polishing composition of 100 wt% was prepared by adding 0.3 wt% of colloidal ceria as an abrasive particle, 2.7 wt% of KONION SM-30 from Green Chemical as a polyoxyalkylene-based surfactant, 1.2 wt% of tetramethylethylenediamine as a skew inhibitor, and 0.35 wt% of polyacrylic acid as an anionic polymer dispersant to ultrapure water as a solvent.

Example 2: A polishing composition of 100 wt% was prepared under the same conditions as in Example 1, except that 2.0 wt% of polyoxyalkylene-based surfactant and 1.6 wt% of skew inhibitor were applied.

Example 3: A polishing composition of 100 wt% was prepared under the same conditions as in Example 1, except that 1.6 wt% of skew inhibitor was applied.

Example 4: A polishing composition of 100 wt% was prepared under the same conditions as in Example 1, except that 3.3 wt% of polyoxyalkylene-based surfactant and 1.6 wt% of skew inhibitor were applied.

Example 5: A polishing composition of 100 wt% was prepared under the same conditions as in Example 1, except that 2.0 wt% of skew inhibitor was applied.

Comparative Example 1: A polishing composition of 100 wt% was prepared under the same conditions as Example 1, except that 0.6 wt% of polyoxyalkylene-based surfactant and 0.8 wt% of skew inhibitor were applied.

The composition, pH, zeta potential, and diameter of the abrasive particle (secondary grain) of the polishing composition for each example and comparative example are listed in Table 1 below.

**Evaluation Example: Measurement of Dishing Value measured from Silicon Oxide Film and Skew Value measured from Silicon Nitride Film**

The polishing composition of each example and each comparative example was applied to polish a substrate containing a silicon nitride film and a silicon oxide film, having a smooth surface, and having a pattern density of 50% for 200 seconds. The polishing pad was an HD-500C from SK enpulse Co., Ltd., the carrier/table speed was 93/87 RPM, the slurry flow rate was 100 ml/min, and the polishing pressure was 4 psi.

After polishing, the step height of the polished silicon oxide film was measured, and the value was used as the dishing value of the silicon oxide film.

In addition, the maximum polished depth of the polished silicon nitride film was measured, and the value was used as the skew value of the silicon nitride film.

The measurement results for each example and each comparative example are shown in Table 2 below.

**Evaluation Example: Measuring Polishing Rate and Frequency of Scratches on** a **Polished Surface**

The polishing composition of each example and each comparative example was applied to polishing a silicon nitride film wafer and a silicon oxide film wafer for 60 seconds each. A polishing pressure of 4.0 psi was applied during polishing.

After polishing, the removed thickness of the silicon oxide film and the silicon nitride film in the substrate was measured, and the polishing rate was calculated from the above measurements. Then, from the values of the polishing rate of the silicon oxide film and the polishing rate of the silicon nitride film, the polishing selectivity ratio of the silicon oxide film to the silicon nitride film was calculated.

In addition, the number of scratches formed on the substrate after polishing was measured with a wafer defect detector, the AIT-XP+ model from KLA Tencor.

The measurement results for each example and comparative example are shown in Table 2 below.

[Table 1]

| | Abrasive particle (wt%) | Polyoxy alkylene -based | Skew Suppre ssors | $R_{S/O}$* | Anionic Polymeric Dispersants | pH | Zeta Potential (mV) | Diameter of Abrasive |
|---|---|---|---|---|---|---|---|---|
| | | Surfact ants (wt%) | (wt%) | | (wt%) | | | particle (nm) |
| Example 1 | 0.3 | 2.7 | 1.2 | 0.44 | 0.35 | 7.4 | -46.1 | 149 |
| Example 2 | 0.3 | 2.0 | 1.6 | 0.80 | 0.35 | 7.6 | -47.1 | 152 |
| Example 3 | 0.3 | 2.7 | 1.6 | 0.59 | 0.35 | 7.5 | -52.8 | 151 |
| Example 4 | 0.3 | 3.3 | 1.6 | 0.48 | 0.35 | 7.7 | -39.5 | 150 |
| Example 5 | 0.3 | 2.7 | 2.0 | 0.74 | 0.35 | 7.7 | -47.9 | 153 |
| Comparative Example 1 | 0.3 | 0.6 | 0.8 | 1.33 | 0.35 | 7.5 | -48.3 | 153 |
| * $R_{S/O}$: Ratio of skew inhibitor content (wt%) to polyoxyalkylene-based surfactant content (wt%) | | | | | | | | |

[Table 2]

| | Dishing Value measured from Silicon Oxide Film (Å) | Skew Values measured from Silicon Nitride Film (Å) | Polishing Rate for Silicon Oxide Film (Å/min) | Polishing Rate for Silicon Nitride Film (Å/min) | Polishing Selectivity Ratio of Silicon Oxide Film to Silicon Nitride Film | Frequency of Scratches on the Polishing Surface (Number/Wa fer) |
|---|---|---|---|---|---|---|
| Example 1 | 385 | 112 | 1424 | 82 | 17.4 | 543 |
| Example 2 | 116 | 100 | 1380 | 71 | 19.4 | 656 |
| Example 3 | 143 | 77 | 1443 | 45 | 32.1 | 529 |
| Example 4 | 358 | 91 | 1424 | 54 | 26.4 | 567 |
| Example 5 | 519 | 80 | 1434 | 65 | 22.1 | 605 |
| Comparative Example 1 | 1067 | 139 | 1464 | 96 | 15.3 | 638 |

In Table 2 above, for the dishing values of the silicon oxide film, Examples 1 to 5 show 520 Å or less, while Comparative Example 1 show more than 1,000 Å.

For the skew value of the silicon nitride film, Examples 1 to 5 show 115 Å or less, while Comparative Example 1 show more than 135 Å.

For the polishing selectivity ratio, Examples 1 to 5 exhibit a value of 17 or greater, while Comparative Example 1 exhibits a value of less than 15.5.

This means that if the ratio of the content of the skew inhibitor to the content of the polyoxyalkylene-based surfactant is adjusted within a predetermined range in the present disclosure, the dishing value of the silicon oxide film and the skew value of the silicon nitride film can be reduced to a certain level or less, while exhibiting an excellent polishing selectivity ratio.

In terms of the number of scratches on the polished surface, the Examples and Comparative Examples were less than 700. This means that the dispersibility of the abrasive particle was effectively improved by the addition of the anionic polymeric dispersant.

While this disclosure includes specific examples, it will be apparent after an understanding of the disclosure of this application that various changes in form and details may be made in these examples without departing from the spirit and scope of the claims and their equivalents. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above and all drawing disclosures, the scope of the disclosure is also inclusive of the claims and their equivalents, i.e., all variations within the scope of the claims and their equivalents are to be construed as being included in the disclosure.

## Claims

**1.** A polishing composition for a semiconductor process, the polishing composition comprising:

abrasive particles;
a polyoxyalkylene-based surfactant; and
a skew inhibitor of Formula 1 below:

[Formula 1]

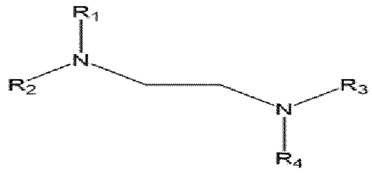

wherein, in Formula 1:
$R_1$ is H, a methyl group, or an ethyl group; and
$R_2$, $R_3$, and $R_4$ are each independently a methyl or ethyl group, and
wherein the hydrophile-lipophile balance (HLB) value of the polyoxyalkylene-based surfactant is 13 or higher.

**2.** The polishing composition of claim 1, wherein the polyoxyalkylene-based surfactant is a compound of Formula 2:

[Formula 2]

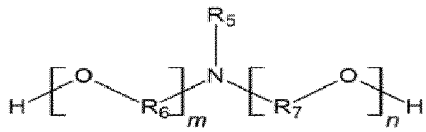

wherein, in Formula 2,
$R_5$ is an alkyl group having 10 to 30 carbon atoms;
$R_6$ and $R_7$ are each independently a methyl group or an ethyl group; and
m and n are each independently an integer from 10 to 30.

**3.** The polishing composition of claim 1, wherein a ratio of a content (by weight) of the skew inhibitor to a content (by weight) of the polyoxyalkylene-based surfactant is from 0.3 to 1.2.

**4.** The polishing composition of claim 1, wherein a weight average molecular weight of the polyoxyalkylene-based surfactant is from 500 g/mol to 4,000 g/mol.

**5.** The polishing composition of claim 1, further comprising an anionic polymeric dispersant,
wherein a surface charge of the abrasive particle is positive.

**6.** The polishing composition of claim 5, wherein the anionic polymeric dispersant comprises at least one compound selected from the group consisting of polyacrylic acid, polymethacrylic acid, polymaleic acid, and derivatives thereof.

**7.** The polishing composition of claim 1, wherein the polishing composition has a pH of 5.5 to 12.

**8.** The polishing composition of claim 1, wherein the polishing composition has a zeta potential of -80 mV to -20 mV.

**9.** The polishing composition of claim 1, wherein the polyoxyalkylene-based surfactant is a dishing inhibitor for silicon oxide films, and the skew inhibitor is for silicon nitride films.

**10.** A method of manufacturing a substrate, the method comprising:

polishing a substrate to be polished by applying a slurry of a polishing composition, wherein the polishing composition comprises:

abrasive particles;
a polyoxyalkylene-based surfactant; and
a skew inhibitor of Formula 1 below:

[Formula 1]

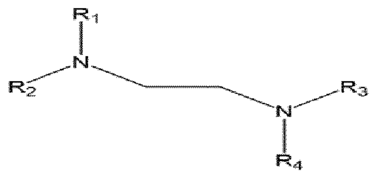

wherein, in Formula 1:

$R_1$ is H, a methyl group, or an ethyl group; and
$R_2$, $R_3$, and $R_4$ are each independently a methyl or ethyl group, and
wherein the hydrophile-lipophile balance (HLB) value of the polyoxyalkylene-based surfactant is 13 or higher.

Europäisches Patentamt
European Patent Office
Office européen des brevets

# EUROPEAN SEARCH REPORT

Application Number
EP 24 20 2658

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/124195 A1 (PARK HYU-BUM [KR] ET AL) 26 May 2011 (2011-05-26) | 1-10 | INV. C09G1/02 C09K3/14 |
| Y | * paragraphs [0030] - [0043], [0046] - [0048]; examples 1-4; tables 1-4 * | 2 | |
| X | CN 109 971 362 B (ZUO HAIZHEN) 15 December 2020 (2020-12-15) * claims 1-5; examples 1-3 * | 1,8-10 | |
| X | KR 2020 0053213 A (SOULBRAIN CO LTD [KR]) 18 May 2020 (2020-05-18) | 1-10 | |
| Y | * paragraphs [0045] - [0047], [0050] - [0058], [0064], [0074]; claims 1-3,5,6-15; examples 1-4 * | 1-10 | |
| Y | KR 2019 0071268 A (KCTECH CO LTD [KR]) 24 June 2019 (2019-06-24) * paragraphs [0018], [0019], [0043] - [0048], [0052], [0053]; claims 1-17; examples 1-8; tables 1-3 * | 1-10 | |
| A | JP 2020 105345 A (KAO CORP) 9 July 2020 (2020-07-09) * claims 1-3 * | 1-10 | |

| TECHNICAL FIELDS SEARCHED (IPC) |
|---|
| C09G |
| F16D |
| C09K |

The present search report has been drawn up for all claims

2

| Place of search | Date of completion of the search | Examiner |
|---|---|---|
| Munich | 4 February 2025 | Schmitt, Johannes |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 20 2658

This annex lists the patent family members relating to the patent documents cited in the above-mentioned European search report. The members are as contained in the European Patent Office EDP file on
The European Patent Office is in no way liable for these particulars which are merely given for the purpose of information.

04-02-2025

| Patent document cited in search report | Publication date | Patent family member(s) | Publication date |
|---|---|---|---|
| US 2011124195 A1 | 26-05-2011 | CN 102131885 A | 20-07-2011 |
| | | JP 2011529269 A | 01-12-2011 |
| | | KR 20100011030 A | 03-02-2010 |
| | | US 2011124195 A1 | 26-05-2011 |
| | | WO 2010011080 A2 | 28-01-2010 |
| CN 109971362 B | 15-12-2020 | NONE | |
| KR 20200053213 A | 18-05-2020 | NONE | |
| KR 20190071268 A | 24-06-2019 | NONE | |
| JP 2020105345 A | 09-07-2020 | JP 7236270 B2 | 09-03-2023 |
| | | JP 2020105345 A | 09-07-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- KR 1020230133164